# EUROPEAN PATENT APPLICATION

(11) **EP 2 149 796 A1**
(43) Date of publication of application: **03.02.2010**
(21) Application number: 08425535.5
(22) Date of filing: 01.08.2008
(51) Int. Cl.: G01R 31/36, H01M 10/48

(54) **Apparatus and method for analysing the state of maintenance and efficiency of batteries, especially for industrial and/or commercial vehicles**

(71) Applicant: Iveco S.p.A., 10156 Torino (IT)
(72) Inventor: Cerrato, Roberto, 10094 Giaveno (IT); Poletto, Paolo, 10095 Grugliasco (IT)
(74) Representative: Borsano, Corrado

(57) **Abstract**

Described herein is an apparatus and method for analysing the state of maintenance and efficiency of batteries, especially for industrial and/or commercial vehicles, the apparatus and method comprising: one or more storage units (TAG RFID) designed to be integrated in one or more vehicle batteries (BAT), and designed to store data on maintenance operations and identification information; one or more measuring instruments (TST) designed to make measurements of characteristic parameters of said batteries; and one or more read/write devices (RFID R/W) connected to the measuring instruments (TST), designed to read and write said data from/in said one or more storage units (TAG RFID).

## Description

### Field of the invention

The present invention relates to an apparatus and method for analysing the state of maintenance and efficiency of batteries, especially for an industrial and/or commercial vehicle.

### State of the art

The battery installed on board vehicles, especially industrial and/or commercial vehicles, has at least three purposes:
- starting the engine;
- supplying the energy support to the vehicle in the event of malfunctioning of the engine or of the alternator, for example, for the following systems: check on engine; check on braking; lighting / light signalling, intermittent lights, light system, above all in the cases of emergency, and
- guaranteeing usability of the services in the cab (heating, radio, ventilation, etc.) when the vehicle is standing still, even with the engine turned off.

It is hence evident that the battery plays a fundamental role in the context of proper operation of the vehicle.

An intrinsic behaviour of the battery is the reduction of the performance over time. If properly maintained, the life expectancy of the battery can be significantly long (e.g., longer than four years); otherwise, it may drop to just a few months.

The battery tends to run down easily also with the engine turned off, given the high and increasing number of on-board electronic apparatuses that need to be supplied even when the engine is turned off, whether they are in stand-by or are turned on.

Battery maintenance is fundamental especially in the initial steps, during the period of warranty, and also subsequently. The absence of maintenance entails an increase in the costs of general management and under warranty.

For example, in the case of need for assistance on the vehicle due to the battery, to the direct costs for battery replacement there may be added the ones deriving from the possible need to tow the vehicle 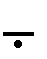

The rate of degeneration of the performance of the battery is fast so that it is necessary to make frequent checks on its characteristics such as to provide objective data, and it must be possible to keep track on all the steps of the checks to be able to trace the effective origin of the problems also for reasons of responsibility under warranty or during maintenance contract.

There is hence the need to provide both a system and an objective procedure for checking the state of the batteries that will be carried out with sufficient frequency, and will not depend upon individual "sensations" or decisions, for example, of the driver or the person responsible for maintenance.

### Summary of the invention

Consequently, the purpose of the present invention is to provide an apparatus and method for analysing the state of maintenance and efficiency of batteries, especially for industrial and/or commercial vehicles, that will enable the performance of the battery to be guaranteed over time.

The subject of the present invention is an apparatus for analysing the state of maintenance and efficiency of batteries, especially for industrial and/or commercial vehicles, said apparatus comprising:
- one or more storage units designed to be integrated in one or more vehicle batteries, said storage units being designed to store the data on the maintenance operations and identification information;
- one or more measuring instruments designed to make measurements of characteristic parameters of said batteries; and
- one or more read/write devices connected to said one or more measuring instruments, designed to read and write said data from/in said one or more storage units.

Moreover forming the subject of the present invention is a battery, especially for industrial and/or commercial vehicles, that comprises an integrated storage unit and is designed to store data on maintenance operations and information for identification of the battery and/or vehicle.

Likewise forming a subject of the present invention is a method for analysing the state of maintenance and efficiency of batteries, especially for industrial and/or commercial vehicles, which uses said apparatus and said battery.

A particular subject of the present invention is an apparatus and method for analysing the state of maintenance and efficiency of batteries, especially for industrial and/or commercial vehicles, as will be described more fully in the annexed claims, which form an integral part of the present description.

### Brief description of the figures

The purposes and advantages of the present invention will emerge clearly from the ensuing detailed description of an example of embodiment thereof (and of its variants), as well as from the annexed drawings, provided purely by way of non-limiting explanation, in which:
- Figure 1 is a block diagram of the system for analysing the state of maintenance and efficiency of batteries, especially for industrial and/or commercial vehicles, which forms the subject of the invention; and
- Figures 2.1, 2.2, 2.3, 3.1, 3.2, 3.3, 3.4 are flowcharts of the operations performed for analysing the state of maintenance and efficiency of the battery in accordance with the invention.

### Detailed description of an example of embodiment

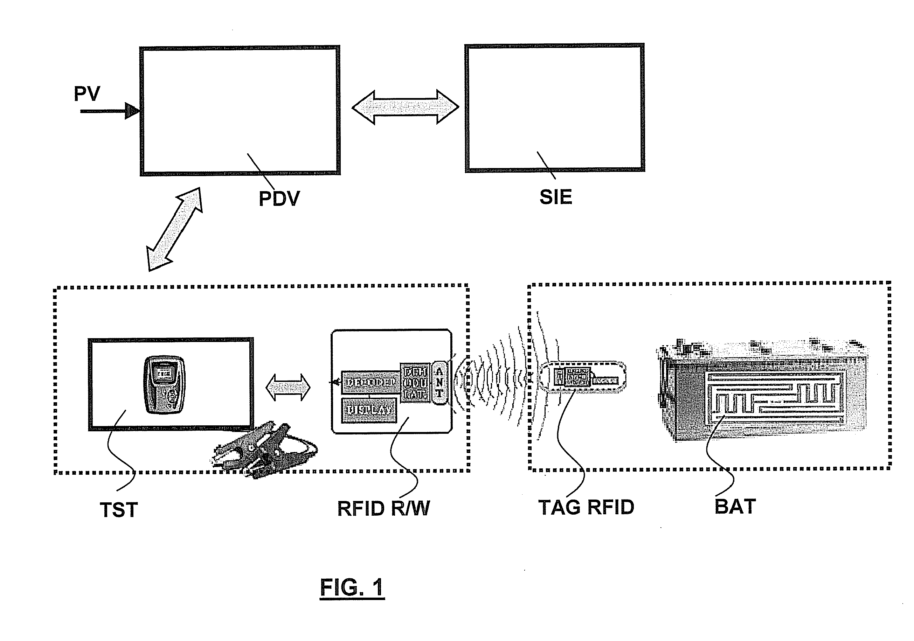

The apparatus forming the subject of the invention is now described in detail with reference to its principal constituent modules highlighted in Figure 1.

The apparatus enables storage in the battery of information for keeping track of the maintenance operations performed on the battery, and basically comprises the following elements:
A) A battery BAT, modified in accordance with the invention, i.e., integrated in which is a device, referred to in what follows as RFID TAG, to be applied on the battery, which is the storage unit that stores the maintenance operations and the identification information, in order to make available an electronic tag fixed to the battery; it should be noted that more than one battery can be installed on a single vehicle; for example, there may often be two batteries installed on an industrial and/or commercial vehicle; hence such a device can be integrated in each of the batteries.
B) An instrument for measuring the characteristics of the battery, i.e., a tester TST of a type in itself known, for making electrical measurements on the battery, for example equipped with cables and clamps for connection to the battery terminals, and designed to make measurements, for example of the following parameters:
   - maximum current that can be delivered by the battery so as to be able to guarantee a sufficient supply voltage for the electrical and electronic loads, also guaranteeing starting of the engine at low temperatures; and
   - residual or remaining capacity: i.e., the maximum amount of energy that can be accumulated in the battery.
C) A device for reading and writing the RFID TAG, referred to in what follows as RFID R/W.
D) A vehicle diagnostic platform PDV, of a type in itself known, designed to interface in a known way with the vehicle electronic control unit for reading the vehicle parameters PV, and designed to interface with the RFID R/W for reading the information necessary for keeping track of the battery-maintenance operations.
E) A possible external information system SIE that drives and controls the different operations, for example the vehicle diagnostic platform PDV.
   It is to be noted that the system SIE can also include the PDV.
F) A possible centralized server, for enabling storage of the data obtained, for example via the Internet, designed to interact with one or more vehicle diagnostic platforms PVD or with the information system SIE.

More in particular, as regards the RFID TAG device the following specifications are made.

RFID (Radio Frequency Identification) is a technology for automatic identification of objects that may even be animated. The system is based upon remote reading and/or writing of information from/in a read/write element, referred to as RFID TAG, or also as transponder, which is substantially constituted by:
- a microchip containing data (amongst which a universal unique number)
- an antenna
- a possible battery.

The RFID TAG is able to receive the information contained in the chip and transmit it via radiofrequency to a RFID transceiver, referred to as RFID R/W.

There exist different types of RFID TAGS, substantially of types in themselves known, which work at normalized frequencies, for example, 125/134 kHz, 13.56 MHz, 868/915 MHz, >2.4 GHz.

Some are of a passive type; others are active or semi-active.

The active ones are supplied by batteries, whereas the semi-active ones are supplied by batteries only to maintain the internal circuit part active whilst for irradiation they use a part of the energy received from the radio wave that also transmits the information, whilst the passive ones do not have internal sources of supply, but draw energy from the radio wave sent by the RFID R/W that queries them to be activated and retransmit the data.

The microchip (of very small dimensions) is the "smart" part, constituted by a non-volatile memory containing a single code, which is transmitted via the antenna (signal-transmission circuit) to the apparatus RFID R/W, which controls the data received. In the passive type, the RFID R/W emits an electromagnetic field, which, via the process of induction, generates in the antenna a current that supplies the microchip. The latter communicates all its information, which is irradiated via the antenna to the RFID R/W.

The active types, instead, are supplied by a small internal battery (active RFIDs).

The read/write mode enables not only a transmission of information but also updating thereof on the microchip. There is thus obtained an identification system that can keep track of the history of a product right from the production step and then be used in an interactive way throughout the process up to retail distribution and in some cases up to the consumer.

The transponder and antenna are inserted in a support that characterizes the specific use of each of these objects.

There are known different types of embodiments of RFID TAGS: inserted in labels or within cards of a credit-card format, or else in the form of stickers, etc.

More in particular, the device RFID R/W is constituted by a circuit that emits electromagnetic energy through an antenna, and by an electronics that receives and decodes the information sent by the transponder RFID TAG and sends it to the data-collection system. The communication between the RFID TAG and the RFID R/W takes place in four steps:
a) the RFID R/W energizes the RFID TAG;
b) the RFID R/W issues commands for querying the RFID TAGS that can be reached;
c) the RFID R/W listens to the replies of the RFID TAGS; and
d) the RFID R/W communicates the result of the reading to the outside world.

The communication between the RFID R/W and the RFID TAGS that can be reached is made through the antennas, which are the elements that irradiate the electromagnetic signal. These antennas are of a type in itself known but their design depends upon the particular use, namely upon the spectrum of frequencies used, the conditions of installation of the RFID TAGS in the battery, the distance between the reader and the TAG, to determine proper coupling between the chip and the antenna.

According to one aspect of the invention, the RFID TAG is integrated in the battery, in different possible modes, e.g., in the lid, or else floating within the battery liquid, or adhesive with protective coating that reveal any attempts at tampering.

It is preferable to provide a reading of a short-range type, e.g., 10 cm, for different reasons: to prevent the TAGS of other nearby vehicles from possibly being read, to prevent fraudulent readings, etc. For instance, the antenna can be embedded in the clamps of the tester TST to be connected to the battery. Hence the type of transmission and antenna are sized for a short-range connection.

As regards the types of information that can be stored in RFID TAGS, during the step of production of the battery data identifying the type of battery are stored in the RFID TAGS such as, for example: model; production date/lot; information on service, for example whether the destinations of use are hot or cold climates; testing date.

There are also performed different operations of checking, the result of which can be stored in the electronic tag.

During the steps of production of the vehicle and of installation of the battery on board, it is possible to associate the battery to the vehicle via data stored in the RFID TAGS, for example the vehicle identification number (VIN). The obvious advantage is that of being able to link vehicle/battery and vehicle mission, and hence that of being able to provide weighted diagnostic information on the type of use. For example, the fatigue of a battery for a city vehicle is very different from that of a vehicle for motorway use (from one engine start every 10 km travelled to one engine start every 200 km travelled).

During the subsequent steps of maintenance and check of the battery, track is kept on maintenance life of the battery, which, for instance, may be distinguished between before and after delivery to the end customer, i.e., between the moment of production and that of actual use of the vehicle. Keeping track of the maintenance life consists in executing operations of checking followed by diagnostic indications and indications of intervention. Then, these details are also saved in RFID TAGS.

Having available vehicle diagnostic information matched with the information on board the battery (filed in the electronic tag and updated, for example, at the moment of updating of the periodic-maintenance coupon) enables a diagnostic approach that up to now was not possible: for example, it becomes possible to identify the state of efficiency or of health of the battery and of its compatibility with the type of mission of the vehicle. Given the results, there derives therefrom the possibility of recommending maintenance operations and/or replacement of the battery or diagnostic suggestions.

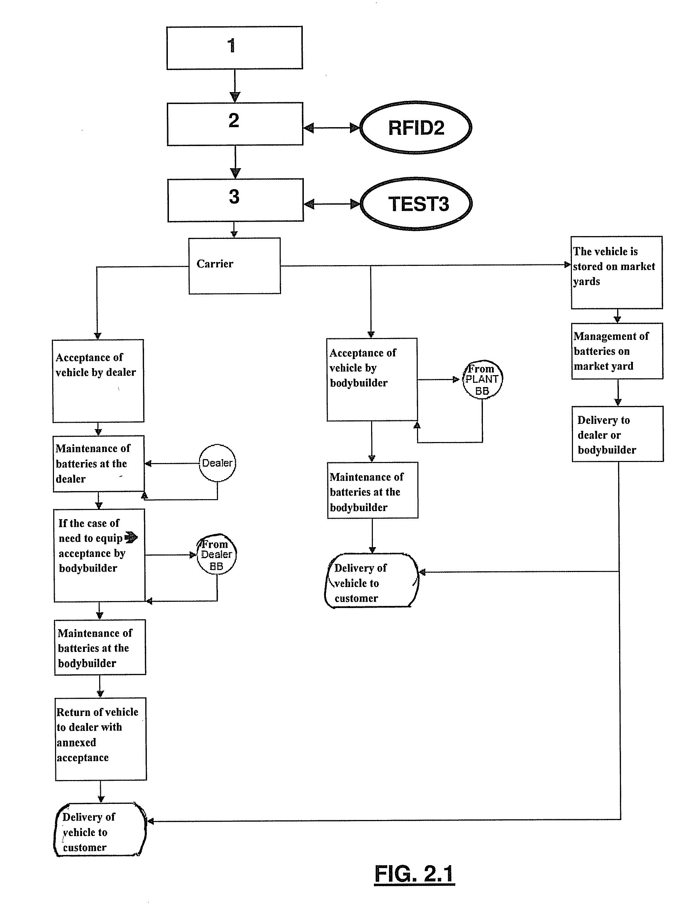

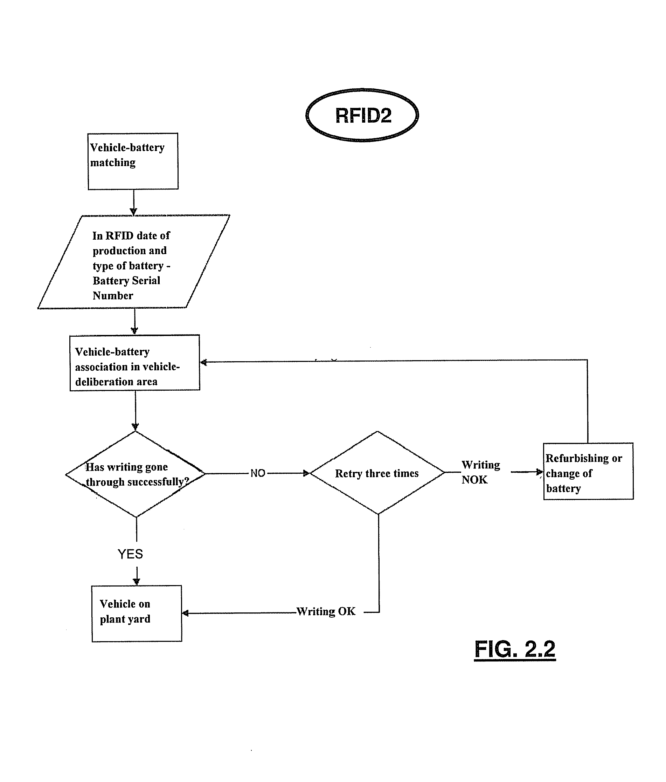

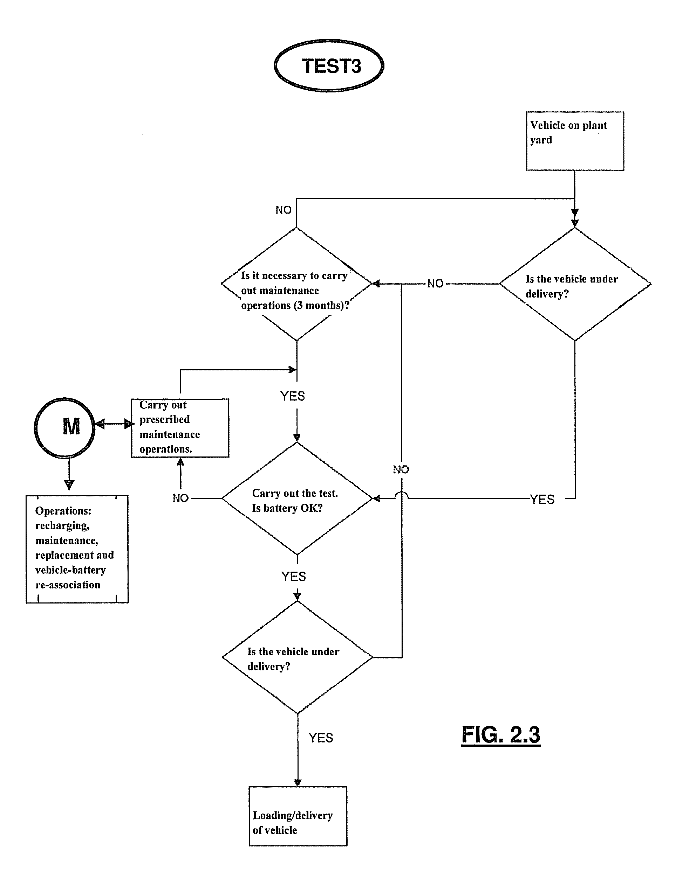

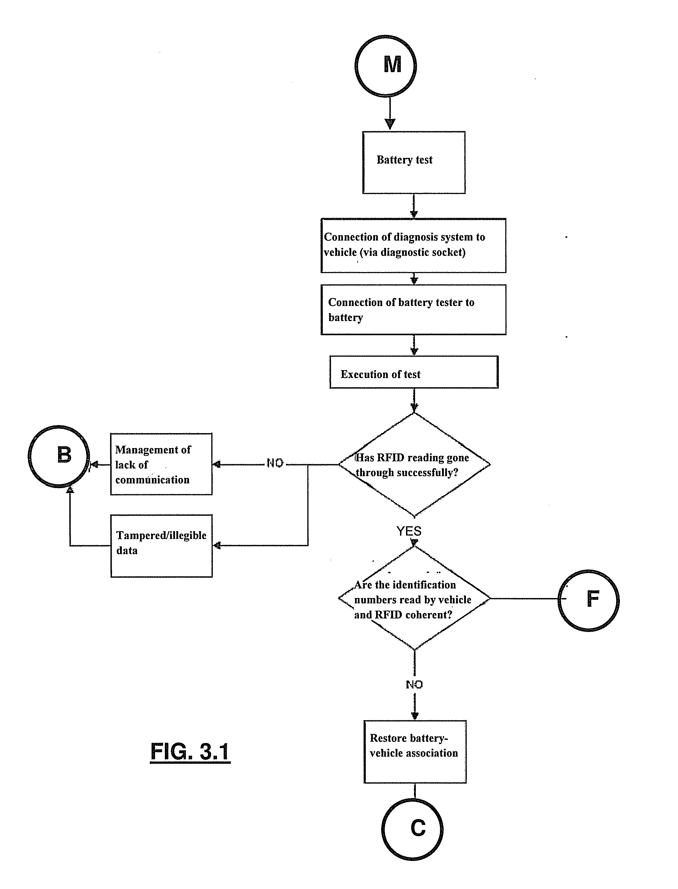

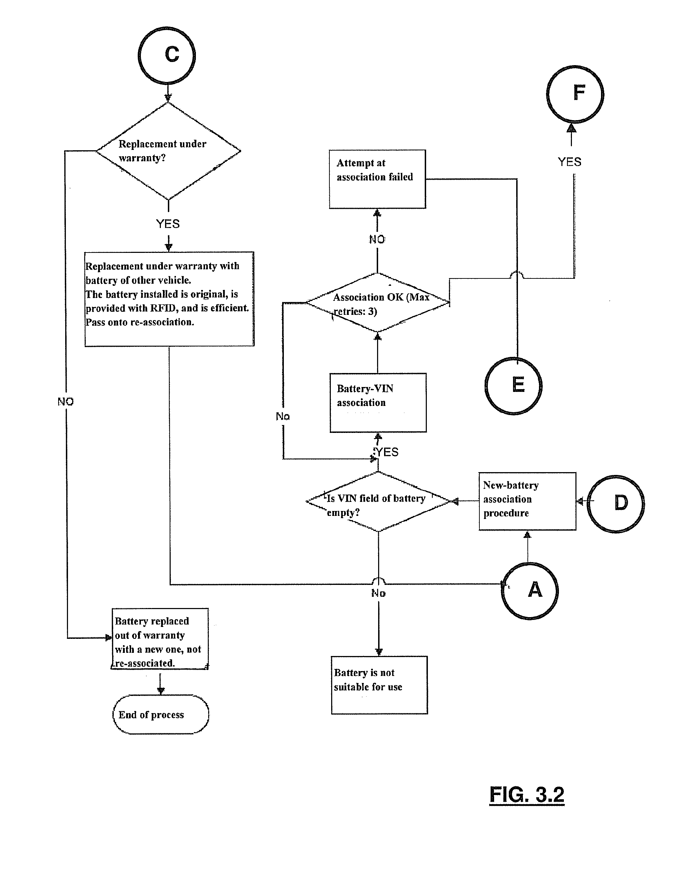

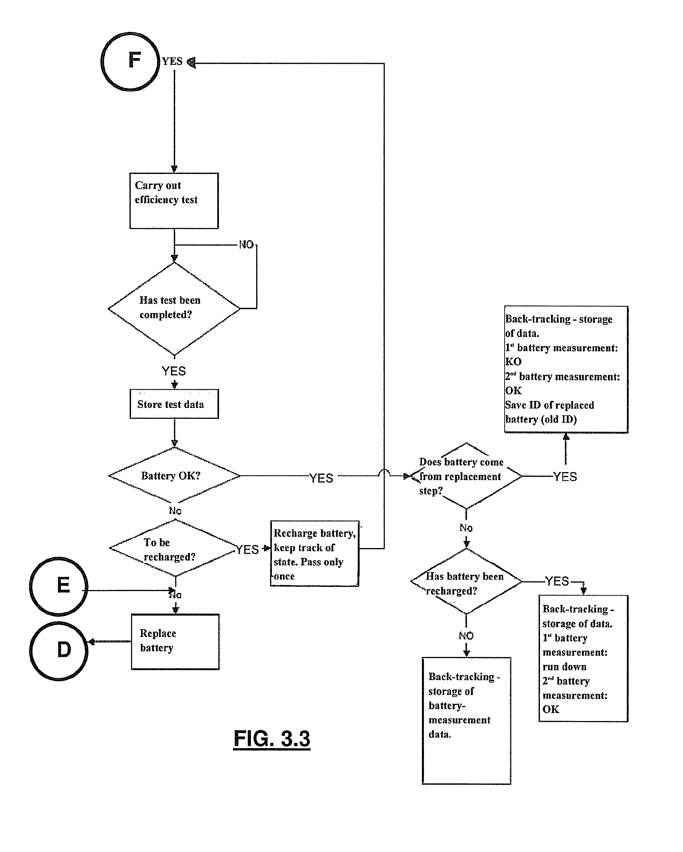

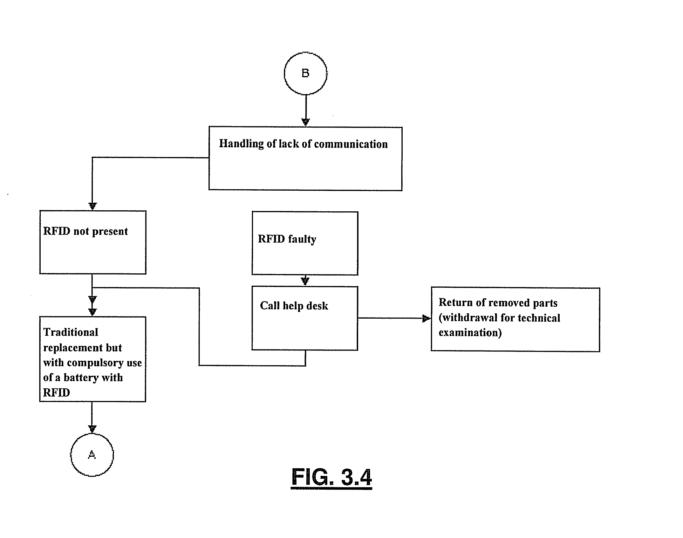

Described in greater detail in what follows is an example of embodiment of the flow of operations performed for analysing battery wear in accordance with the invention, with reference to Figures 2.1, 2.2, 2.3, 3.1, 3.2, 3.3, 3.4.

In effect, the main aspects of the details of the operative flows visible in the figures are described, said figures being self-explanatory for said details, which hence do not require any further detailed description in so far as the person skilled in the branch is perfectly able to implement them.

As already mentioned above, in the initial steps, at the time of production of the vehicle identification numbers of vehicle characteristics and configuration are defined, such as, for example, VIN (Vehicle Identification Number) and PIC (Product ID Code) (step 1). These numbers are uniquely associated to the battery by being written in the RFID TAG, where the data identifying the type of battery have already been written (steps 2, and RFID2, Figures 2.1, 2.2).

There may also be performed operations of cross-checking of data identifying the vehicle and the battery, for checking their proper association, for example to prevent non-authorized uses or replacements of the battery.

If the two vehicle identification numbers (VINs) of the vehicle and of the battery are the same, then the operations are correct; otherwise, an error is signalled in the process of maintenance, and for example the fault can be signalled to the centre.

In the subsequent steps of management of the vehicle being produced (site defined as "near plant") testing procedures start with data stored in the RFID TAGS (steps 3 and TEST 3, Figures 2.1, 2.3). The procedures are periodic (for example, once every three months).

At a given moment, the vehicle leaves the production site possibly by means of a carrier, who delivers it definitively to a dealer or else temporarily to a body builder or else to the end customer (see the next steps in Figure 2.1).

Also in these steps, the periodic procedures of check on the state of maintenance and efficiency of the batteries are in any case performed, said procedures being represented in detail in the flowcharts of Figures 3.1-3-4, which start by picking up from point M (Figure 2.3).

The operations may comprise recharging, replacement, vehicle-battery re-association, re-assignment of codes identifying the new battery, which may have been installed regularly or not, on the basis of the individual program for programmed maintenance.

The functions described can be executed via computer programs, which may reside in one or more electronic processing units, integrated together or else subdivided among the various units in co-operation. Said computer programs comprise encoding means for execution of one or more steps of the functions described above when these programs are run on a computer. Consequently, it is understood that the sphere of protection of the present invention extends to said computer programs and moreover to computer-readable means that comprise a recorded message, said computer-readable means comprising program-coding means for execution of one or more steps of the functions described above when said program is run on a computer.

Also possible are variant embodiments of the non-limiting example described, without this implying any departure from the sphere of protection of the present invention, including all the embodiments that are equivalent for a person skilled in the branch.

There clearly emerge the advantages deriving from application of the present invention, as follows:
- maximization of the working life of the battery components;
- minimization of the replacements of the batteries for reasons of inadequate maintenance;
- reduction of the cases of the vehicle being out of running order owing to unforeseen faults of the battery;
- reduction of the cases of inefficiency and risks of unusability;
- provision of a diagnostic apparatus that identifies whether the battery is still compatible with the vehicle characteristics;
- feedback to design department for product improvements;
- feedback to the user in order to correct any possible energy abuse of the vehicle;
- reduction in costs for the user due to the vehicle being out of running order; and
- reduction of the environmental impact owing to optimization of the use of the batteries.

From the foregoing description, a person skilled in the branch will be able to achieve the object of the invention without introducing further constructional details. In particular, the computer programs can be developed on the basis of programming languages, in themselves known, of any type used in the sphere of application of the present invention.

## Claims

1. An apparatus for analysing the state of maintenance and efficiency of batteries, especially for industrial and/or commercial vehicles, the apparatus comprising:
- one or more storage units (RFID TAGS), designed to be integrated in one or more vehicle batteries (BAT), said one or more storage units being designed to store data on maintenance operations and identification information;
- one or more measuring instruments (TST), designed to make measurements of characteristic parameters of said batteries;
- one or more read/write devices (RFID R/W), connected to said one or more measuring instruments (TST), designed to read and write said data from/in said one or more storage units (RFID TAGS).

2. The apparatus for analysing the state of maintenance and efficiency of batteries as per Claim 1, moreover comprising a vehicle diagnostic platform (PDV), designed to interface with vehicle control units for reading vehicle parameters (PV), and designed to interface with said one or more read/write devices (RFID R/W) for reading said information in one or more storage units (RFID TAGS) and for determining information for keeping track of the battery-maintenance operations.

3. The apparatus for analysing the state of maintenance and efficiency of batteries as per Claim 2, moreover comprising:
- an external information system (SIE), designed to control said vehicle diagnostic platform (PDV).
- a centralized server, for enabling storage of the data obtained, designed to interact with one or more platforms (PVD) or with the information system (SIE).

4. The apparatus for analysing the state of maintenance and efficiency of batteries as per Claim 1, in which said one or more storage units (RFID TAGS) are transponders integrated in the batteries.

5. The apparatus for analysing the state of maintenance and efficiency of batteries as per Claim 4, in which said one or more storage units (RFID TAGS) are integrated in the lid of the battery, or else floating within the battery liquid, or else are adhesive with protective coatings.

6. The apparatus for analysing the state of maintenance and efficiency of batteries as per Claim 1, in which said one or more storage units (RFID TAGS) and said one or more read/write devices (RFID R/W) are designed to provide a communication of a short-range type.

7. The apparatus for analysing the state of maintenance and efficiency of batteries as per Claim 6, in which said one or more measuring instruments (TST) are equipped with antenna embedded in the clamps for connection to the battery to provide said short-range communication.

8. A method for analysing the state of maintenance and efficiency of batteries, especially for industrial and commercial vehicles, by means of an apparatus for analysing wear of batteries as per any one of the preceding claims, comprising the following steps:
- storing in said one or more storage units (RFID TAG) data identifying the type of battery, during the steps of production of the battery;
- storing in said one or more storage units (RFID TAG) data identifying the vehicle, during the steps of production of the vehicle and/or of installation of the battery on board the vehicle;
- storing in said one or more storage units (RFID TAG) data on the battery maintenance operations during the steps of maintenance and checking of the battery.

9. The method for analysing the state of maintenance and efficiency of batteries as per Claim 8, comprising the step of using the data stored in said one or more storage units (RFID TAG) for keeping track of the state of efficiency of the battery in order to determine operations of maintenance and/or replacement of the battery or diagnostic suggestions.

10. A battery, especially for industrial and/or commercial vehicles, comprising an integrated storage unit (RFID TAG), and designed to store data on maintenance operations and information on identification of the battery and/or the vehicle.

11. The battery as per Claim 10, in which said storage unit (RFID TAG) is a transponder.

12. The battery as per Claim 11, in which said storage unit (RFID TAG) is integrated in the lid of the battery, or else floating within the battery liquid, or else is adhesive with a protective coating.

13. A computer program that comprises program-coding means, designed to execute the functions of Claims 8 and 9, when said program is run on a computer.

14. Computer-readable means comprising a recorded program, said computer-readable means comprising program-coding means designed to execute the functions according to Claims 8 and 9, when said program is run on a computer.
